# EUROPEAN PATENT APPLICATION

(11) **EP 4 819 432 A1**
(43) Date of publication of application: **07.10.2026**
(21) Application number: 26169059.8
(22) Date of filing: 30.03.2026
(51) Int. Cl.: H02J 3/388, H02J 3/38

(54) **ISLANDING CONDITION DETECTION METHOD**

(30) Priority: 01.04.2025 CN 202510402393
(71) Applicant: Delta Electronics (Thailand) Public Co., Ltd., Samutprakarn 10280 (TH)
(72) Inventor: Cai, Yili, 201209 Shanghai (CN); Bao, Licheng, 201209 Shanghai (CN); Sun, Jia, 201209 Shanghai (CN); Zheng, Peiqi, 201209 Shanghai (CN); Liao, Yongkai, 201209 Shanghai (CN)
(74) Representative: Uexküll & Stolberg

(57) **Abstract**

An islanding condition detection method for an inverter (1) is provided. The inverter (1) is electrically connected to a power grid (3). Firstly, an active injection stage (S1) is performed to control the inverter (1) to inject a reactive current into the power grid (3) at least once and detect whether a grid frequency (*f*_{ac}) of the power grid (3) is within a preset frequency range. Then, a detection stage (S2) is performed to detect at least one of an output voltage (Vo), an output current (Io) and a frequency of the inverter (1), a detection result of the detection stage (S2) is converted into a detection value, and a preset reference value is subtracted from the detection value. Consequently, a detection difference value is obtained. If the detection difference value is greater than a preset threshold, an islanding condition occurs, and then the inverter (1) is disabled.

## Description

### FIELD OF THE INVENTION

The present disclosure relates to a detection method for an electronic circuit, and more particularly to an islanding condition detection method.

### BACKGROUND OF THE INVENTION

A grid-connected inverter can be used to convert direct current (DC) power into alternating current (AC) power. In addition, the AC power outputted from the grid-connected inverter can be synchronized with the frequency and phase of the power grid and fed back to the power grid. Since the grid-connected inverter is connected to the power grid, it is necessary to consider the impact of an islanding condition. The islanding condition is a phenomenon where the grid-connected photovoltaic system continuously supplies power to a portion of the grid lines after a sudden voltage loss in the power grid. When the islanding condition occurs, the entire grid-connected photovoltaic system and the connected loads are at risk of severe damage. In order to prevent unintended occurrence of the islanding condition, it is necessary to detect the islanding condition.

Currently, the islanding condition detection methods are mainly divided into two categories, i.e., passive methods and active methods.

The passive methods mainly detect the occurrence of the islanding conditions by monitoring the changes of various electrical parameters in the grid-connected inverter. However, the passive methods suffer from drawbacks such as large detection blind zones, low accuracy, and poor effectiveness.

In accordance with the active methods, small disturbances are introduced into the grid-connected inverter to enable faster detection of the islanding condition. The common active methods include an active frequency drift (AFD) method, a slip-mode frequency shift (SMS) method and a Sandia frequency shift (SFS) method. The advantages of the active methods include smaller detection blind zones and higher accuracy. However, the active methods still face limitations in detection speed. In addition, the active methods may introduce harmonic interference into the power grid.

To overcome the drawbacks of the conventional technologies, it is important to provide an improved islanding condition detection method.

### SUMMARY OF THE INVENTION

The present disclosure provides an islanding condition detection method with high accuracy, fast detection speed and small harmonic interference.

In accordance with an aspect of the present disclosure, an islanding condition detection method for an inverter is provided. The inverter is electrically connected to a power grid. The islanding condition detection method includes the following steps. Firstly, an active injection stage is performed to control the inverter to inject a reactive current into the power grid at least once and detect whether a grid frequency of the power grid is within a preset frequency range. When the grid frequency is within the preset frequency range, the injected reactive current is a first reactive current, which is alternately changed between a positive amplitude and a negative amplitude. When the grid frequency is lower than a lower limit of the preset frequency range, the injected reactive current is a second reactive current. When the grid frequency is greater than an upper limit of the preset frequency range, the injected reactive current is a third reactive current. Then, a detection stage is performed to detect at least one of an output voltage, an output current and a frequency of the inverter, a detection result of the detection stage is converted into a detection value, and a preset reference value is subtracted from the detection value. Consequently, a detection difference value is obtained. When the detection difference value is greater than a preset threshold, an islanding condition occurs, and then the inverter is disabled.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a flowchart illustrating the steps of an islanding condition detection method according to an embodiment of the present disclosure;
FIG. 2 is a schematic circuit diagram illustrating the circuitry topology of an inverter using the islanding condition detection method of the present disclosure; and
FIG. 3 is a schematic timing waveform diagram of the reactive current injected into the output terminal of the inverter when the grid frequency is within a preset frequency range, greater than the upper limit of the preset frequency range, and less than the lower limit of the preset frequency range.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

The block diagrams shown in the accompanying figures represents functional entities only and do not necessarily correspond to physically separate entities. These functional entities may be implemented in software form, or may be realized in one or more hardware modules or integrated circuits, or may be distributed across different networks and/or processor devices and/or microcontroller devices. Additionally, the flowcharts shown in the figures are provided for illustrative purposes only and do not necessarily include all content and operations/steps, nor must they be executed in the described sequence. For example, certain operations/steps may be further divided, while others may be combined or partially merged. Therefore, the actual execution sequence may vary depending on the specific implementation.

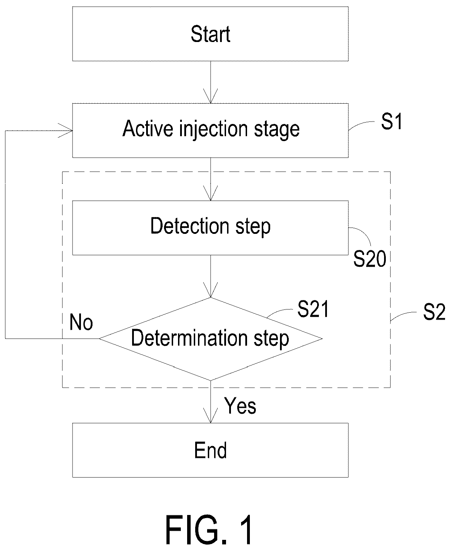

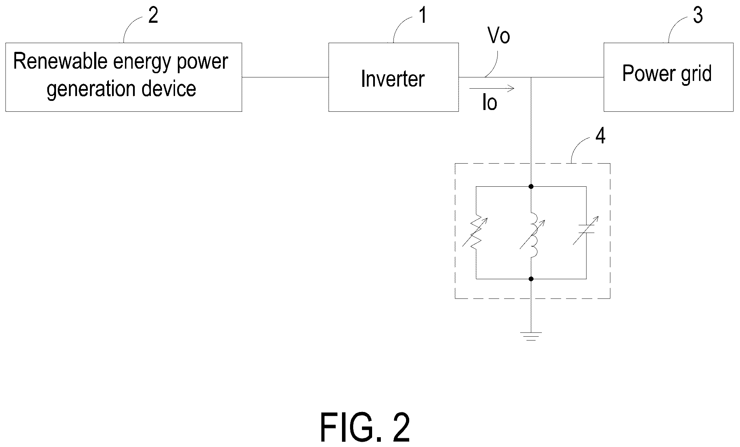

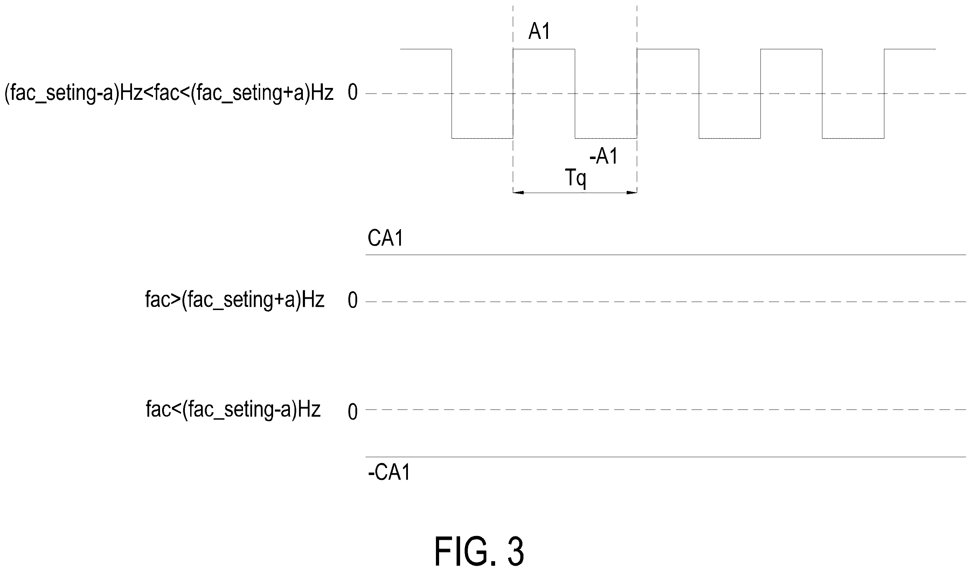

Please refer to FIGS. 1, 2 and 3. FIG. 1 is a flowchart illustrating the steps of an islanding condition detection method according to an embodiment of the present disclosure. FIG. 2 is a schematic circuit diagram illustrating the circuitry topology of an inverter using the islanding condition detection method of the present disclosure. FIG. 3 is a schematic timing waveform diagram of the reactive current injected into the output terminal of the inverter when the grid frequency is within a preset frequency range, greater than the upper limit of the preset frequency range, and less than the lower limit of the preset frequency range.

The islanding condition detection method can be applied to the inverter 1 shown in FIG. 2. In addition, the islanding condition detection method can be executed by a server, a terminal device, a mobile terminal device, or any other appropriate computing device. The input terminal of the inverter 1 is electrically connected with a renewable energy power generation device 2. Preferably but not exclusively, the renewable energy power generation device 2 is a photovoltaic power generation device, a wind power generation device, a hydropower generation device, or any other appropriate DC power generation device. The inverter 1 receives an input electric energy from the renewable energy power generation device 2. The output terminal of the inverter 1 is electrically connected to a power grid 3. The inverter 1 converts the received input electric energy, and the inverter 1 outputs an output voltage Vo and an output current Io from the output terminal.

The islanding condition detection method of the present disclosure includes an active injection stage S1 and a detection stage S2.

In the active injection stage S1, the inverter 1 is controlled to inject a reactive current into the power grid at least once according to the grid frequency of the power grid 3, and detects whether the grid frequency of the power grid 3 is within a preset frequency range.

If the grid frequency is within the preset frequency range, the reactive current injected into the output terminal of the inverter 1 is a first reactive current, which is alternately changed between a positive amplitude and a negative amplitude. If the grid frequency is lower than a lower limit of the preset frequency range, the injected reactive current is a second reactive current. If the grid frequency is greater than an upper limit of the preset frequency range, the reactive current injected into the output terminal of the inverter 1 is a third reactive current.

In the detection stage S2, at least one of an output voltage Vo, an output current Io and a frequency of the inverter 1 is detected. The detection result is converted into a corresponding detection value. After a preset reference value is subtracted from the detection value, a detection difference value is obtained. If the detection difference value is greater than a preset threshold, it is determined that an islanding condition occurs, and the inverter is subsequently disabled.

In the detection stage S2, the detection speed of the islanding condition is actually dependent on the characteristics of the load 4. However, in the conventional islanding condition detection method, if the impedance of the load 4 closely matches the impedance of the inverter (i.e., close to a resistive load), the islanding condition detection time will be very long. Furthermore, if the impedance of the load 4 completely matches the impedance of the inverter (i.e., purely a resistive load), the islanding condition detection method may lead to failure because there is no phase angle.

In the islanding condition detection method of the present disclosure, the reactive current is actively injected into the output terminal of the inverter 1 in the active injection stage S1. When the impedance of the load 4 approaches the impedance of the inverter 1 and the grid frequency begins to increase or decrease, the injected reactive current will cause the grid frequency to deviate more rapidly from its nominal value. This also results in a quicker phase shift between the output voltage Vo and the output current Io. Consequently, the islanding condition can be detected more rapidly. Furthermore, if a corresponding change in the grid frequency is observed after the injection of the reactive current, a larger amount of reactive current (e.g., K times the previous value, where K > 1) can be injected again. Consequently, a positive feedback mechanism is established to further accelerate the detection speed of the islanding condition.

As mentioned above, if the grid frequency is within the preset frequency range, the injected reactive current is the first reactive current, which is alternately changed between the positive amplitude and the negative amplitude. That is, its average value is zero. Consequently, the operation of the inverter 1 will not be adversely affected, and the harmonic interference will be minimized.

If the grid frequency is lower than the lower limit of the preset frequency range or greater than the upper limit of the preset frequency range, a larger amount of reactive current is injected again through adjustment. Consequently, the phase shift between the output voltage Vo and the output current Io becomes larger. In the detection stage S2, the detection result is converted into the corresponding detection value, and the detection difference value between the detection value and the preset reference value can reach the preset threshold more rapidly. In other words, the islanding condition detection method of the present disclosure can effectively detect the islanding condition even if the impedance of the inverter completely matches the impedance of the load 4.

Furthermore, in the detection stage S2, the frequency of the output voltage Vo is obtained according to the detection result of the output voltage Vo itself, or the third-order harmonic component of the output current Io is obtained according to the detection result of the output current Io. The preset threshold is previously defined according to the type of parameters used in the detection result. For example, if the detection result obtained in the detection stage S2 is a frequency value, the preset reference value corresponds to a predetermined frequency threshold.

Especially, in a variant example of the detection stage S2, a current phase is calculated according to the current grid frequency and used as the detection value, and an independent phase prior to X periods is calculated according to the grid frequency at that time and used as the preset reference value, wherein X is an integer greater than or equal to 1. Consequently, the phase difference between the current phase and the independent phase is the detection difference value.

In an embodiment, the detection stage S2 includes a detection step S20 and a determination step S21. In the detection step S20, at least one of the output voltage Vo, the output current Io and the frequency is detected. In the determination step S21, the detection result of the detection step S20 is converted into a corresponding detection value, and the detection difference value between the detection value and the preset reference value is obtained. If the detection difference value is greater than the preset threshold, it is determined that an islanding condition occurs, and the inverter is subsequently disabled. Whereas, if the detection difference value is lower than or equal to the preset threshold, it is determined that the islanding condition does not exist, and the active injection stage S1 is performed again.

As shown in FIG. 3, the preset frequency range is (*f*_{ac_seting}-a, *f*_{ac_seting}+a) Hz, wherein *f*_{ac_seting}-a is the lower limit of the preset frequency range, *f*_{ac_seting}+a is the upper limit of the preset frequency range, *f*_{ac_seting} is the preset frequency, and a is the adjustment value. The preset frequency is the grid frequency before the islanding condition occurs.

If the grid frequency *f*_{ac} is within the preset frequency range, the reactive current injected into the output terminal of the inverter is the first reactive current. The first reactive current has a period T_{q} and an amplitude A₁. The period T_{q} is b times the period of the output current Io, wherein b is a positive number. If the grid frequency *f*_{ac} is lower than the lower limit of the preset frequency range, the injected reactive current is the second reactive current. The second reactive current has an amplitude -CA₁, wherein C is a positive number. In response to the negative amplitude of the second reactive current, the frequency shifts in a decreasing direction, which is consistent with the shift direction of the current grid frequency. If the grid frequency *f*_{ac} is greater than the upper limit of the preset frequency range, the injected reactive current is the third reactive current. The third reactive current has an amplitude CA₁, wherein C is a positive number. In response to the positive amplitude of the third reactive current, the frequency shifts in an increasing direction, which is consistent with the shift direction of the current grid frequency. Since the frequency shift speed increases, the islanding condition can be detected more easily.

In an embodiment, the absolute value of the positive amplitude of the first reactive current and the absolute value of the negative amplitude of the first reactive current are equal. In an embodiment, the amplitude of the second reactive current is in direct proportion to the difference between the grid frequency and the lower limit of the preset frequency range, and the amplitude of the third reactive current is in direct proportion to the difference between the grid frequency and the upper limit of the preset frequency range.

In the active injection stage S1, the amplitude of the reactive current injected into the output terminal of the inverter 1 is K times the amplitude of the previously injected reactive current, wherein K is greater than 1. This approach utilizes a positive feedback mechanism of the inverter 1 to accelerate the deviation of the grid frequency, thereby enabling faster detection of the islanding condition.

In an example of the detection stage S2, the output current Io of the inverter 1 is detected to determine the third-order harmonic component of the current. The third-order harmonic component of the current is used as the detection value. If the difference between the detection value and a preset third harmonic reference value exceeds a corresponding preset threshold, it is determined that an islanding condition occurs, and the inverter is subsequently disabled.

In a variant example, a preset count number is defined. If the number of times the detection difference value is greater than the preset threshold exceeds the preset count number, it is determined that the islanding condition occurs. If the detection difference value is lower than the preset threshold or the number of times the detection difference value is greater than the preset threshold does not exceed the preset count number, it is determined that the islanding condition does not exist.

In the embodiment of FIG. 3, the first reactive current has the waveform of a square wave. It is noted that the waveform of the first reactive current is not restricted. For example, in another embodiment, the first reactive current has the waveform of a sine wave.

From the above descriptions, the present disclosure provides the islanding condition detection method. In the active injection stage, the reactive current is actively injected into the output terminal of the inverter. The injected reactive current will cause the grid frequency to deviate more rapidly from its nominal value. This also results in a quicker phase shift between the output voltage and the output current. Consequently, the islanding condition can be detected more rapidly. In addition, the harmonic interference will be minimized. In addition, when the grid frequency is lower than the lower limit of the preset frequency range or greater than the upper limit of the preset frequency range, a larger amount of reactive current is injected again through adjustment. Consequently, the phase shift between the output voltage and the output current becomes larger. In the detection stage, the detection difference value can reach the preset threshold more rapidly. In other words, the islanding condition detection method of the present disclosure can effectively detect the islanding condition even if the impedance of the inverter completely matches the impedance of the load.

## Claims

1. An islanding condition detection method for an inverter (1), the inverter (1) being electrically connected to a power grid (3), **characterized in that** the islanding condition detection method comprises steps of:
performing an active injection stage (S1) to control the inverter (1) to inject a reactive current into the power grid (3) at least once and detect whether a grid frequency (*f*_{ac}) of the power grid (3) is within a preset frequency range, wherein
when the grid frequency (*f*_{ac}) is within the preset frequency range, the injected reactive current is a first reactive current, which is alternately changed between a positive amplitude and a negative amplitude;
when the grid frequency (*f*_{ac}) is lower than a lower limit of the preset frequency range (*f*_{ac_seting}-a), the injected reactive current is a second reactive current;
wherein when the grid frequency is greater than an upper limit of the preset frequency range (*f*_{ac_seting}+a), the injected reactive current is a third reactive current;
performing a detection stage (S2) to detect at least one of an output voltage (Vo), an output current (Io) and a frequency of the inverter (1), converting a detection result of the detection stage (S2) into a detection value, and subtracting a preset reference value from the detection value, so that a detection difference value is obtained; and
when the detection difference value is greater than a preset threshold, determining that an islanding condition occurs, and then disabling the inverter (1).

2. The islanding condition detection method according to claim 1, wherein when the output voltage (Vo) of the inverter (1) is detected in the detection stage (S2), the detected output voltage is directly used as the detection value, or wherein when the frequency of the inverter (1) is detected in the detection stage (S2), the detected frequency is directly used as the detection value.

3. The islanding condition detection method according to claim 1, wherein when the output current (Io) of the inverter (1) is detected in the detection stage (S2), a third-order harmonic component is obtained according to the detected output current, and the third-order harmonic component is used as the detection value.

4. The islanding condition detection method according to claim 1, wherein in the detection stage (S2), a current phase is calculated according to a current grid frequency, an independent phase prior to X periods is calculated according to the grid frequency (*f*_{ac}) prior to the X periods, and a phase difference between the current phase and the independent phase is calculated, wherein X is an integer greater than or equal to 1, the current phase is the detection value, and the independent phase is the preset reference value.

5. The islanding condition detection method according to claim 1, wherein an absolute value of the positive amplitude of the first reactive current and an absolute value of the negative amplitude of the first reactive current are equal.

6. The islanding condition detection method according to claim 1, wherein an amplitude of the second reactive current is in direct proportion to a difference between the grid frequency (*f*_{ac}) and the lower limit of the preset frequency range (*f*_{ac_seting}+a), and an amplitude of the third reactive current is in direct proportion to a difference between the grid frequency (*f*_{ac}) and the upper limit of the preset frequency range (*f*_{ac_seting}-a).

7. The islanding condition detection method according to claim 1, wherein the first reactive current has the waveform of a square wave or a sine wave.

8. The islanding condition detection method according to claim 1, wherein the upper limit of the preset frequency range (*f*_{ac_seting}+a) is equal to a sum of a preset frequency (*f*_{ac_seting}) and an adjustment value (a), and the lower limit of the preset frequency range (*f*_{ac_seting}-a) is equal to a result of subtracting the adjustment value (a) from the preset frequency (*f*_{ac_seting}).

9. The islanding condition detection method according to claim 1, wherein when the output current (Io) of the inverter (1) is detected in the detection stage (S2), a third-order harmonic component is obtained according to the detected output current, and the third-order harmonic component is used as the detection value, wherein when a number of times the detection difference value is greater than the preset threshold exceeds the preset count number, it is determined that the islanding condition occurs, and the inverter (1) is disabled.

10. The islanding condition detection method according to claim 1, wherein an amplitude of the reactive current injected each time is K times an amplitude of the reactive current injected in a previous time, wherein K > 1.
